# EUROPEAN PATENT SPECIFICATION

(11) **EP 2 575 186 B1**
(45) Date of publication and mention of the grant of the patent: **16.03.2016**
(21) Application number: 11183379.4
(22) Date of filing: 30.09.2011
(51) Int. Cl.: H01L 35/32

(54) **Use of a thermal electric generator in a portable device**
Verwendung eines thermischen elektrischen Generators in einer tragbaren Vorrichtung
Utilisation d'un générateur électrique thermique dans un dispositif portable

(43) Date of publication of application: 03.04.2013
(73) Proprietor: BlackBerry Limited, Waterloo, ON N2K 0A7 (CA)
(72) Inventor: Rich, David Gerard, West Bloomfield, Michigan 48322 (US); Sutarwala, Taha Shabbir Husain, Waterloo, Ontario N2L 3W8 (CA); Morgan, Garry Owen, Waterloo, Ontario N2L 3W8 (CA)
(74) Representative: Moore, Barry

(56) References cited:
- EP-A1- 1 043 781
- WO-A1-02/21609
- JP-A- 8 037 323
- JP-A- 2004 056 866
- JP-A- 2007 042 895
- JP-A- 2010 171 180
- US-A- 5 232 286
- US-A- 6 112 525
- US-A1- 2005 039 465
- US-A1- 2006 086 118
- US-A1- 2009 205 696
- US-A1- 2010 163 542

## Description

### FIELD OF THE DISCLOSURE

The present disclosure is directed at a portable device and more specifically at a system for use of a thermal electric generator in a portable electronic device.

### BACKGROUND

Portable electronic device use has continued to increase and is expected to continue as new products come to market. Some of these portable electronic devices may be handheld, that is, sized and shaped to be held or carried in a human hand. Many individuals now own portable electronic devices such as a mobile communication device (such as a cellular phone or a smart phone),, an MP3 music player, a remote control, an electronic navigation device (such as a Global Positioning System device), a portable DVD player, a portable digital assistant (PDA) or a portable computer (such as a tablet computer or laptop computer). With such a high reliance on portable devices, the need for reliable power sources has also increased.

With the 4^{th} generation development of Universal Mobile Telecommunications system (UMTS) and long term evolution (LTE) communication systems, the efficiency of components within portable devices will likely decrease. For instance, power amplifier performance in mobile communication devices may drop below 20% which means that 80% of the power being generated by the power amplifier may be wasted, some of which is seen as waste heat. Therefore, not only does power amplifier efficiency decrease but there may also be excess heat dissipated which can overheat device components or cause other problems relating to the operation of the device.

### SUMMARY

In one aspect, there is provided an energy generator system for a portable device including a component door, the component door including a flat portion and a housing portion, the energy generator system comprising a thermal electric generator (TEG) integrated within the component door, an electronic component for directing current flow within the TEG, a set of sensors integrated with the TEG for determining temperatures within the TEG and a processor for controlling the electronic component based on the determined temperatures.

EP 1043781 discloses a unit to prevent against damage to thermoelectric elements due to horizontal and vertical loading applied to the thermoelectric elements comprising structure for conducting efficiency. A frame 109 and support columns are provided around thermoelectric elements 106. A heat absorbing plate 104 and a heat radiating plate 111 are fixed on and under the frame 109 and support columns. A buffer member 110 with heat conductivity is filled between the thermoelectric elements 106 and the heat absorbing plate 104 or heat radiating plate 109, thus making a unit structure.

### BRIEF DESCRIPTION OF THE DRAWINGS

Embodiments of the present disclosure will now be described, by way of example only, with reference to the attached Figures, wherein:
Figure 1 is a schematic diagram of a rear of portable device;
Figures 2A to 2D are side views of an energy generator system that may be included with or otherwise integrated within a portable device;
Figure 2E is a side view of an energy generator system as a component door of a portable device;
Figure 3 is a schematic diagram illustrating an energy generator system according to one mode of operation;
Figure 4 is a schematic diagram illustrating an energy generator system according to another mode of operation; and
Figure 5 is a flow chart outlining a method according of use of an energy generating system.

### DETAILED DESCRIPTION

The disclosure is directed at the use of an energy generator system, containing a thermal electric generator (TEG), within or otherwise in cooperation with a portable electronic device, such as a mobile communication device, to recover at least some of the energy that might otherwise be lost as waste heat. This waste heat may then be recovered in the form of electrical energy that can then be used or stored for various applications such as, but not limited to, powering the portable device. Although the energy generator system may operate in either a power harvesting mode (in which the system harvests power for use or storage) or a heater/cooling mode (in which the system performs some thermal management, which may include behaving as a heater or cooler), some portable devices may only allow the energy generator system to operate in one of the two modes of operation.
Other portable devices may only allow the energy generator system to operate in either mode simultaneously or individually. In one embodiment, the TEG may operate as a Peltier cooler to cool components within the device to reduce the likelihood of the device overheating. In another embodiment, the TEG is integrated within a component door of the device.

In general, components are "integrated" when they are physically joined to one another (they may also be electrically joined or connected such that electronic signals in one component may be conveyed to another, or mechanically joined such that movement in one component may cause movement in another) such that the components behave as a single unit. Components may be integrated if they are constructed as a one-piece element or unitary structure, or may be integrated if they are adhered, attached or otherwise affixed to one another (the affixing may be, but is not required to be, substantially permanent) such that they are maintained in a substantially fixed relationship.

In another aspect, the energy generator system may be integrated as the component door of a portable device and may comprise a first layer configured to act as a heat sink; a second layer configured to act as a spreader layer; a connector system connecting the first layer to the second layer; and a component to direct a current flow between the first layer and the second layer. In another embodiment, the energy generator system may include a switch allowing for the energy generator system to act as a cooling system.

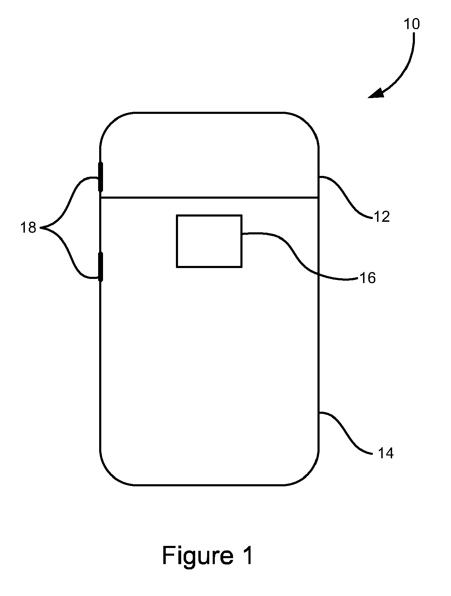

Turning to Figure 1, a rear view of a portable electronic device is illustrated. The portable device may be sized to fit within the palm of a hand, thereby the portable device may be seen as a handheld device. The portable device, such as a mobile communication device, 10 has a rear face, or backing 12, which includes a component door 14 for enclosing a compartment that may house a battery, SIM card, SD card, or other components. In general, the door 14 is a component that is capable of being opened (in some cases, disengaged from and removed entirely from the device 10) so that a user may have access to the interior of the device 10, the compartment and the components in the compartment. The door may protect the compartment from contaminants, protect the components from impacts or the environment, may enhance the aesthetic appearance of the device 10, or may have other functions. The portable device may include a logo or other identifying mark 16 on the component door 14 along with a set of buttons 18, which may be located on a side of the portable device. The portable device may further comprise a display screen, keyboard/keypad, a further set of buttons such as a volume control, and trackball or track pad among other components that may or may not be included in any specific model of the portable device. The portable device 10 includes other parts and components that are not shown or described, as well as other parts or components that may be described below (such as one or more processors).

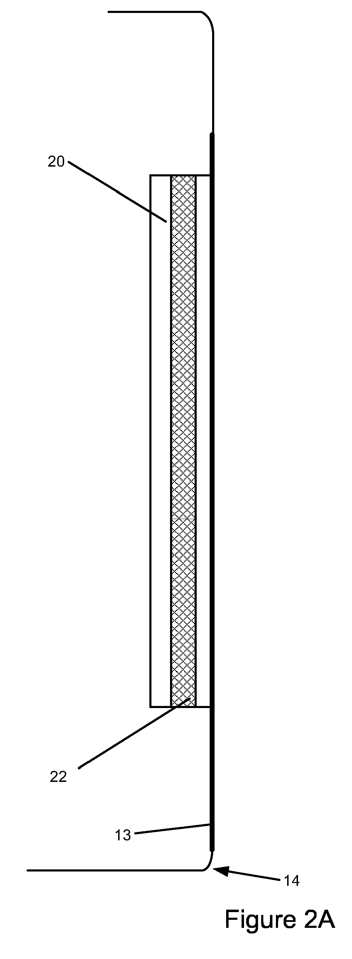

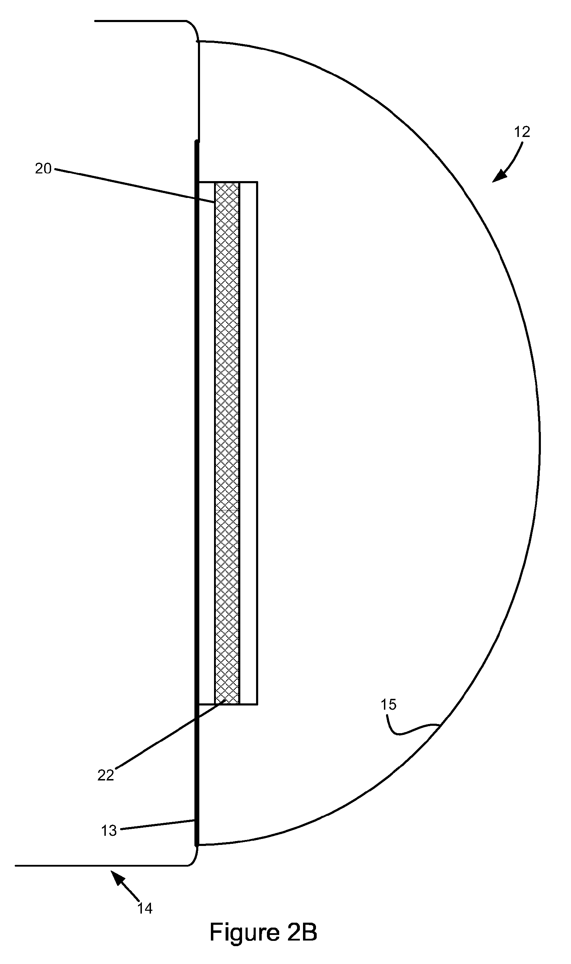

Turning to Figures 2A to 2D, various embodiments of a component door of a portable device including an energy generator system 20 are shown. In each of these embodiments, the energy generator system 20 is integrated with or within the component door 14 of the portable device 10. As shown in Figures 2B to 2D, the component door 14 of the portable device 10 includes a flat portion 13 and a housing portion 15, which may be rounded or otherwise have soft edges or blunt corners or curved contours, to house the energy generator system.

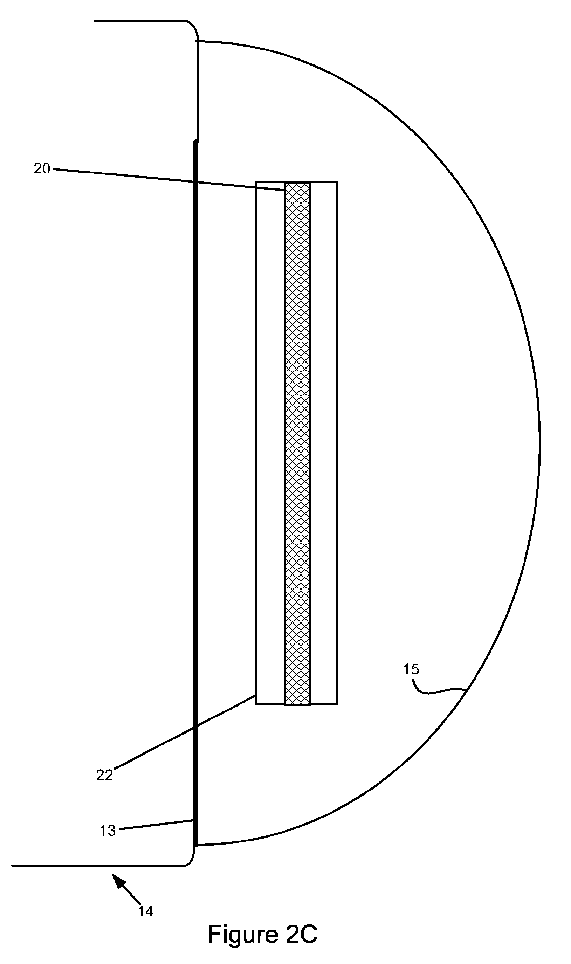

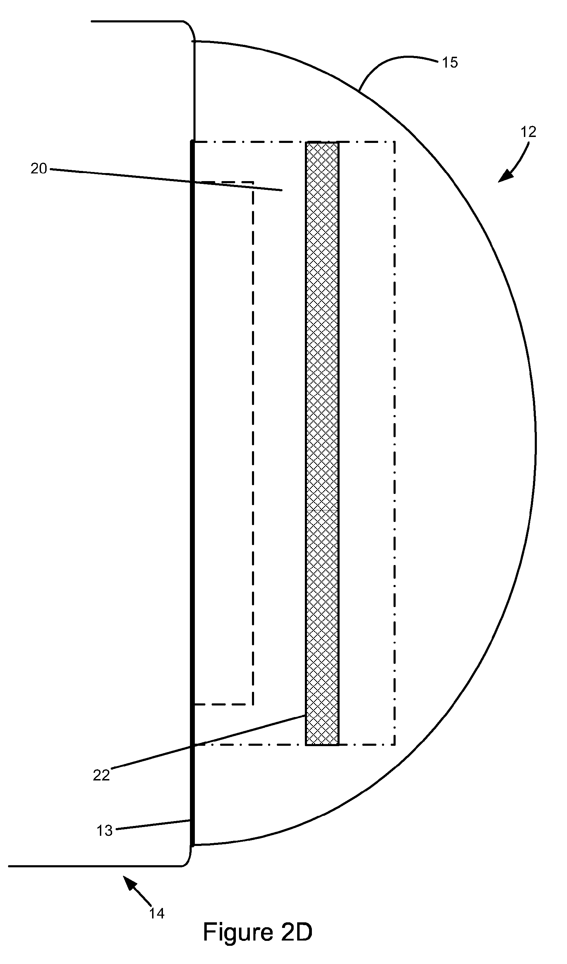

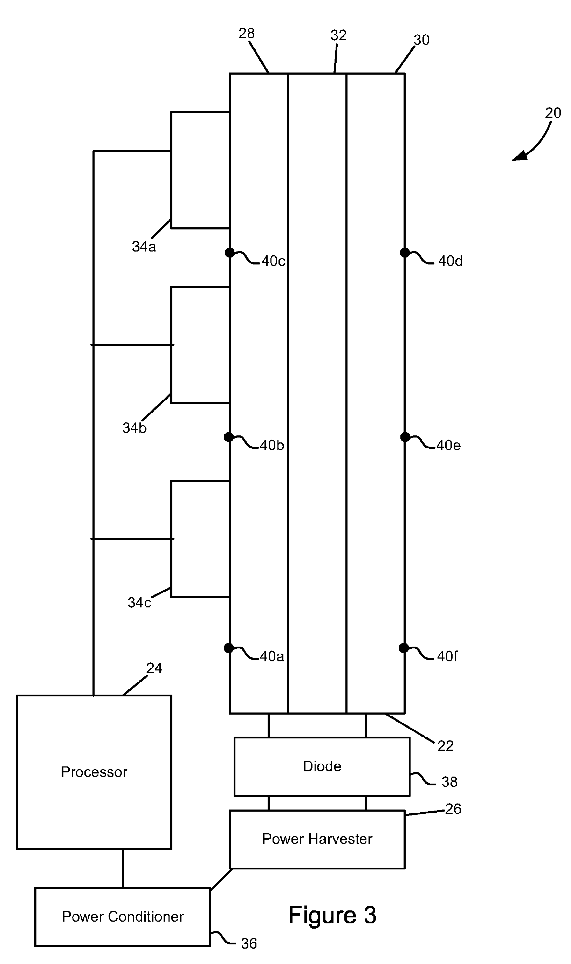

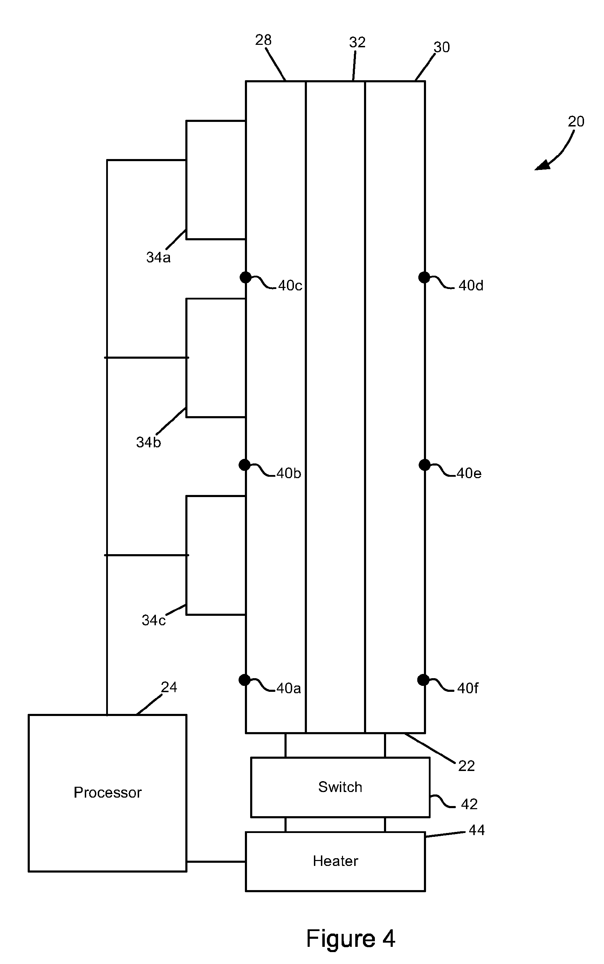

The energy generator system 20 includes a thermal electric generator (TEG) 22, which is shown in more detail in Figures 3 and 4. In the various embodiments shown, the energy generator system 20 is integrated on an inner surface of the flat portion 13 of the component door 14 (Figure 2A), the energy generator system 20 is integrated and flush with an outer surface of the flat portion 13 of the component door (Figure 2B), the energy generator system may be recessed within the housing portion away from the flat portion in a linear configuration (Figure 2C) or the energy generator system may be recessed within the housing portion away from the flat portion in a U-shaped configuration (Figure 2D).

In the embodiment of Figure 2A, the energy generator system is flush with the component door and since the component door 14 is in contact with ambient air, efficiency of the energy generator system may be increased or improved. In this embodiment, the energy generator system 20 may also be used as a cooling system to reduce or prevent an over-heating situation within the device.

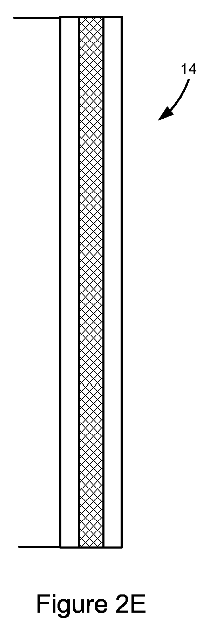

Further, if the energy generator system 20 is flush with the component door or otherwise integrated with the component door 14, the portable device may not need to be increased in size. Although the housing portion 15 of the component door is shown as a rounded portion, this may also be shaped to follow the contour of the energy generator system and may not be as exaggerated as shown in the Figures. As users frequently show a preference for small and compact mobile devices it would be preferable that the energy generator system remain compact and readily adaptable to the already existing or familiar structure of the portable device. As such, it may be preferable that the energy generator system 20 either be incorporated within the portable device (such that when the door is closed, the door and consequently the energy generator system 20 behave as an integrated part of the portable device) or be adapted so that it may function as the component door as shown in Figure 2E. In other words, a user may view the embodiment of Figure 2E aesthetically as a door, when the embodiment of Figure 2E includes additional functionality (which may not be readily visible) as an energy generator system.

Figure 3 illustrates the energy generator system 20 incorporating a TEG 22 in power harvesting mode of operation. In general, a power harvesting mode of operation involves collecting energy, in the form of heat, converting the energy to a more useful form such as electrical energy, which can be used or stored (e.g., in a rechargeable battery). The energy generator system 20 may be operatively connected to a processor 24 via a power harvester 26. (Note that components that are operatively connected to one another are connected so that they operate together and they may be but need not be physically connected to one another. In some cases, components that are operatively connected may be indirectly connected via one or more intermediate elements.) The processor 24 may be, for example, a microprocessor that controls many of the functions of the portable device. The power harvester may be connected to the processor 24 or the device components 34a, 34b, 34c via a power conditioner 36 that may regulate the power being supplied to the processor 24 and device components 34a, 34b, 34c. Conditioning may include controlling or regulating or setting or adjusting any characteristic of electrical energy or power, such as voltage, current, ripple, magnitude, wave shape or frequency. Alternatively, the power harvester 26 may operatively connect directly to the processor 24 or to other device components 34a, 34b, 34c in order to power these components.

The TEG 22 has at least two layers 28, 30, which are connected by a connector layer 32. One layer 28, which may be seen as an electronic component, positive or internal layer, may be in physical contact with the device components 34a, 34b, 34c. This layer 28 is typically a hot surface where intimate contact between the device components 34a, 34b, 34c, or the waste heat created by the components may be distributed along the layer 28. In other words, the component layer 28 may have similar properties to a heat sink.

The inclusion of the internal layer 28 allows the energy generator system 20 to produce, experience or enable, a differential in temperature between the internal layer 28 and the second, free, negative or external layer 30 in order to allow energy to be created by the energy generator system 20. The positive and negative sides may also be known as hot and cold sides of the TEG 22.

The external layer 30 may maintain a temperature which is less than the temperature of the internal layer 28. Alternatively, the temperature of the second layer may be higher than the temperature of the internal layer for instance if the device has been idle or off for a period of time. The second layer may also be a heat spreader layer. In one embodiment, the temperature of the layers 28 and 30 may be determined via the use of sensors.

The connector system 32 connects the two layers 28 and 30. In one embodiment, the two layers 28, 30 may be manufactured from metal or cermet (an alloy of ceramics and metals). The connector system 32, or layer, may comprise a plurality of ceramic, metal fibers or wires, which would allow for heat transfer between the other two layers 28 and 30.

When in the power harvesting mode of operation, the energy generator system 20 may be connected to the power harvester 26 by way of an electronic component such as a diode 38. The diode 38 may be included as part of the energy generator system to ensure for one-way current flow.

As the difference in temperature (ΔT) between the two layers 28 and 30 approaches zero when used as a Peltier cooler efficiency improves, and when used as a TEG the efficiency decreases as ΔT is reduced. As the efficiency increases there may be a change in voltage, which would supply a current from the energy generator system 20 to the power harvester 26. The energy generator system 20 may recover and convert any waste or extra heat to energy that may be transferred and stored in the power conditioner 36 or the power source if it is able to store energy (such as with a rechargeable battery).

The energy generator system 20 may further include a plurality of sensors 40a to 40f. The sensors 40 may determine the temperature of each of the layers 28 and 30. Although three sensors are shown per layer 28, 30, the actual number of sensors 40 may vary as long as each layer 28, 30 includes at least one sensor 40. The temperatures are sensed by the sensors 40 and then transmitted to the processor 24 so that the processor may determine the direction of current flow from the layer having a higher temperature to the layer having the lower temperature in order to generate energy through the use of the TEG 22. In many cases, the internal layer 28, which will likely be heated by the device components 34, will be the layer having the higher temperature.

After being supplied the current, the diode 38 directs current through the internal layer 28 to the connector layer 32 and then the external layer 30 to capture the energy generated by the temperature difference. The energy generated by this current flow is collected by the power harvester 26 and may be delivered to the power conditioner 36 to regulate or store the power. If the power harvester 26 contains a conditioning function, the power may be conditioned by the power harvester and then used to power the components within the portable device.

In operation, there may be situations when it is desirable to have the TEG 22 to operate in a reverse orientation whereby current is transmitted from the external layer 30 to the internal layer 28, thereby indicating that the external layer 30 is a higher temperature than the internal layer 28. For example, if the portable device has been sitting in the sun or on a dashboard of a vehicle, the external layer 30 may be hotter than the internal layer 28. In this situation, the sensors 40 would relay the temperatures of the layers to the processor 24. In another embodiment, the sensors may determine the temperature differential and then transmit this information to the energy generator system 20. The diode 38 would then adjust, or control, the current flow accordingly so that the current flows from the external layer 30 to the first layer 28. If the sensors 40 determine that the external layer 30 is the layer at higher temperature, the energy generator system may generate energy from the ambient environment and transmit this energy to the power harvester 26 which may direct the power to the power source, the power conditioner or other device components. As the layers 28, 30 may be constructed from similar material, each layer may be able to operate as either a heat sink or heat spreader depending on the temperature surrounding each of the layers.

The energy generator system may also operate in a second mode of operation such as a heating/cooling mode. In general, a heating/cooling mode of operation involves physically heating or cooling or both of one or more components. In some embodiments, heating/cooling mode may entail expenditure of energy, while harvesting mode may entail collection and conservation of energy. A schematic diagram of this implementation is shown in Figure 4. In this mode, the energy generator system may employ the use of a switch 42, which may assist in the switching of the energy generator system into this heating/cooling mode from the power harvesting mode of operation. In other words, the switch allows for the energy generator system to operate in one of two modes and also performs the function of the diode when the device is in the power harvesting mode of operation.

In the heating/cooling mode of operation, the power harvester 26 may function as a heater 44. In one aspect, the sensors 40a, 40b and 40c may register that the internal components 34a, 34b, 34c are too cold to operate effectively by determining the temperature of the internal layer 28. The sensors may sense that the temperature of the internal layer 28 is below a threshold temperature where it is known that more heat is required to efficiently operate the components or the power source if the power source is a fuel cell. Once this temperature is detected, the switch 42 may change the energy generator system from its power harvesting mode of operation to the heating and cooling mode of operation. In this mode, the energy generator system may pull heat from the outside ambient air through the external layer 30 to the heater 44, which may then dissipate this heat to the components of the portable device. When the energy generator system is being operated as a heater, any stored energy may be used to heat the device components.

Similarly, the energy generator system may act as a cooling system. In this functionality, the TEG 22 may be a Peltier TEG. If the sensors 40 determine that the internal layer 28 has reached a temperature above a threshold temperature, the switch 42 may switch the mode of the energy generator system to the cooling mode. In this aspect, the switch connects the internal layer 28 to the power harvester 26 or heater 44 to supply current to the overheated internal layer 28. This current causes the internal layer 28 to heat while warming the external layer 30. The effectiveness, or efficiency, of the energy generator system when used for cooling is dependent on the amount of current provided to the TEG 22 and how well the heat may be dissipated once it has been dispersed to the external layer 30.

Depending on where the energy generator system 20 is located in relation to the flat portion 13, the distance between the internal layer 28 and the components 34a, 34b, 34c will be varied. If a location for the energy generator system 20 is selected where the layer 28 is adjacent or touching components 34a, 34b, 34c, an insulator (not shown) may be included. In embodiments where the components are not in direct contact with the internal layer 28, the layer may be positioned so that it is able to absorb heat emitted from these device components. The heat emitted from the components 34a, 34b, 34c would be transmitted or absorbed by the layer 28 and would be transferred through the connector system 32 to the external layer 30, which may act to spread the heat and to return recovered heat that may be converted to energy to the power harvester 26, as described above. Although only three components are shown, the energy generator system 20 may be adjacent to more or less components depending on the internal layout of the portable device.

In one embodiment, the energy generator system 20 may be included with or otherwise integrated with the component door of the portable device. If the component door of the portable device is metal or embedded metal in plastic, the energy generator system may not need to be fully enclosed. In one embodiment, the component door may use a honeycomb or similar pattern to allow for good thermal transfer while maintaining areas, which would remain at a temperature suitable to be touched by the user. Other patterns that maintain protective areas are further contemplated. In another embodiment, the energy generator system may be covered with a high thermally conductive plastic. As an added safety feature, there may be an identifiable area on the rear face of the device for the user to touch the portable device without fear of encountering high or excessive heat. This added feature may be supported by direction of heat, use of materials such as insulation, shape of the device, etc.

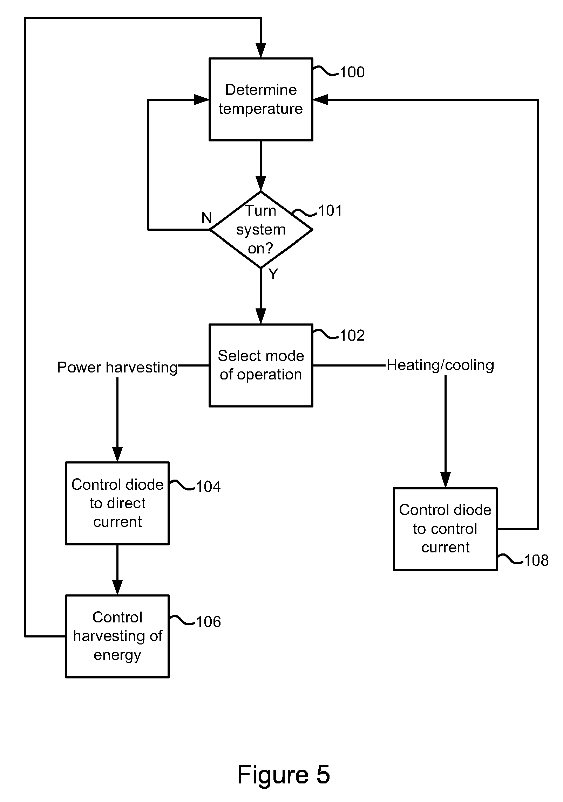

Figure 5 illustrates a method of operation of the energy generator system described above. First, the sensors determine 100 the temperature of each layer, both the internal layer 28 and the external layer 30. Once the temperature of each layer is determined, the temperatures may be compared to threshold levels. Based on this comparison, the processor determines 101 if the energy generator system needs to be activated. For instance, if the temperature of the internal layer is above a maximum threshold level or below a minimum threshold level, the processor determines the energy generator system 20 should enter the heating/cooling mode of operation. In an alternative embodiment, the energy generator system is always on and therefore there is no need to determine if the system should be activated. The processor then transmits a signal to the switch to select the energy generator system mode of operation 102 of heating/cooling. If the temperature is between the threshold levels the switch may select 102 the power harvesting operation mode.

In the power harvesting mode, the processor controls 104 the diode to direct the current flow 104 from the internal layer 28 to the external layer 30 and then controls 106 the collection of the resulting energy 106, which will be passed to the power harvester. In the heating/cooling mode of operation, the processor controls 108 the diode to direct the current flow so that that either the device is heated, by passing warmer environmental air to heat the internal components, or cooled, by allowing heat to dissipate from the overheating internal components. It should be noted that this method may operate in a continuous or substantially continuous loop, where the sensors measure the temperature on a fixed time interval and compare the measured temperatures to the threshold levels. As soon as a temperature is recorded that is outside the threshold, the processor determines the mode of operation of the energy generator system (likely heating and cooling mode of operation), until the temperatures return to within the threshold level or levels.

The figures illustrate the use of the energy generator system 20 incorporated within a communication device, but such a system may be incorporated into other mobile and portable devices. An energy generator system similar to the one described above may be beneficial in a laptop or portable DVD player, where transferring heat to energy may be useful to extend the battery time of these devices. Other portable devices may also be adapted to accept an energy generator system such as the one described above.

Implementation of one or more embodiments may realize one or more advantages, some of which have been mentioned already. The concepts described herein are flexibly adaptable to a variety of devices. Many of the embodiments can be implemented on a relatively small or compact scale, taking up little space and weight. Convenience may be enhanced in that the same components may, depending upon modes of operation, perform more than one function.

In the preceding description, for purposes of explanation, numerous details are set forth in order to provide a thorough understanding of the embodiments of the disclosure. However, it will be apparent to one skilled in the art that these specific details are not required in order to practice the disclosure. In other instances, well-known electrical structures and circuits are shown in block diagram form in order not to obscure the disclosure. For example, specific details are not provided as to whether the embodiments of the disclosure described herein are implemented as a software routine, hardware circuit, firmware, or a combination thereof.

The above-described embodiments of the disclosure are intended to be examples only. Alterations, modifications and variations can be effected to the particular embodiments by those of skill in the art without departing from the scope of the disclosure, which is defined solely by the claims appended hereto.

## Claims

1. An energy generator system (20) for a portable (10) device including a component door (14), the component door (14) including a flat portion (13) and a housing portion (15), the energy generator system (20) comprising:
a thermal electric generator, TEG, (22) integrated within the component door (14);
an electronic component (38, 42) for directing current flow within the TEG (22);
a set of sensors integrated with the TEG (22) for determining temperatures within the TEG (22) ; and
a processor (24) for controlling the electronic component (38, 42) based on the determined temperatures.

2. The energy generator system (20) of Claim 1 wherein the TEG (22) is located on a surface of the flat portion (13), optionally on a surface of the flat portion (13) within the housing portion (15).

3. The energy generator system (20) of any preceding Claim wherein the TEG (22) is located within the housing portion (15).

4. The energy generator system (20) of any preceding Claim wherein the TEG (22) is U-shaped.

5. The energy generator system (20) of any preceding Claim wherein the TEG (22) comprises:
a first layer of metallic material;
a second layer of metallic material; and
a connector system connecting the first layer to the second layer;
wherein the connector system directs current from one of the layers to the other layer.

6. The energy generator system (20) of any preceding Claim wherein the electronic component (38, 42) is a switch.

7. The energy generator system (20) of any preceding Claim wherein the electronic component (38, 42) is a diode.

8. The energy generator system (20) of any preceding Claim further comprising:
a power harvester for collecting energy generated by the TEG.

9. The energy generator system (20) of Claim 8 further comprising:
a power condition component connected between the power harvester and the processor (24).

10. The energy generator system (20) of any preceding Claim wherein the TEG (22) is in direct contact with device components.

11. The energy generator system (20) of Claim 5 wherein the metallic material for the first layer is cermet.

12. The energy generator system (20) of Claim 5 wherein the metallic material for the second layer is cermet.

## Patentansprüche

1. Energiegeneratorsystem (20) für eine tragbare Vorrichtung (10) mit einer Komponententür (14), wobei die Komponententür (14) einen flachen Teil (13) und einen Gehäuseteil (15) aufweist, wobei das Energiegeneratorsystem (20) Folgendes aufweist:
einen thermisch-elektrischen Generator, TEG, (22), der in der Komponententür (14) integriert ist,
eine Elektronikkomponente (38, 42) zum Richten eines Stromflusses in dem TEG (22),
eine Menge von Sensoren, die in dem TEG (22) integriert sind, zum Bestimmen von Temperaturen in dem TEG (22) und
einen Prozessor (24) zum Steuern der Elektronikkomponente (38, 42) auf Grundlage der bestimmten Temperaturen.

2. Energiegeneratorsystem (20) nach Anspruch 1, wobei der TEG (22) auf einer Oberfläche des flachen Teils (13), optional auf einer Oberfläche des flachen Teils (13) in dem Gehäuseteil (15), angeordnet ist.

3. Energiegeneratorsystem (20) nach einem der vorhergehenden Ansprüche, wobei der TEG (22) in dem Gehäuseteil (15) angeordnet ist.

4. Energiegeneratorsystem (20) nach einem der vorhergehenden Ansprüche, wobei der TEG (22) U-förmig ist.

5. Energiegeneratorsystem (20) nach einem der vorhergehenden Ansprüche, wobei der TEG (22) folgendes aufweist:
eine erste Schicht metallischen Materials,
eine zweite Schicht metallischen Materials und
ein Verbindungssystem, das die erste Schicht mit der zweiten Schicht verbindet,
wobei das Verbindungssystem Strom von der einen der Schichten auf die andere der Schichten richtet.

6. Energiegeneratorsystem (20) nach einem der vorhergehenden Ansprüche, wobei die Elektronikkomponente (38, 42) ein Schalter ist.

7. Energiegeneratorsystem (20) nach einem der vorhergehenden Ansprüche, wobei die Elektronikkomponente (38, 42) eine Diode ist.

8. Energiegeneratorsystem (20) nach einem der vorhergehenden Ansprüche, ferner mit:
einem Leistungs- bzw. Strom-Ernte-Element zum Sammeln von von dem TEG erzeugter Energie.

9. Energiegeneratorsystem (20) nach Anspruch 8, ferner mit:
einer Leistungs- bzw. Strom-Zustands-Komponente, die zwischen dem Leistungs- bzw. Strom-Ernte-Element und dem Prozessor (24) verbunden ist.

10. Energiegeneratorsystem (20) nach einem der vorhergehenden Ansprüche, wobei der TEG (22) in unmittelbarem Kontakt mit Vorrichtungskomponenten ist.

11. Energiegeneratorsystem (20) nach Anspruch 5, wobei das metallische Material für die erste Schicht Cermet ist.

12. Energiegeneratorsystem (20) nach Anspruch 5, wobei das metallische Material für die zweite Schicht Cermet ist.

## Revendications

1. Système de générateur d'énergie (20) pour un dispositif portable (10) comportant une porte intégrante (14), la porte intégrante (14) comportant une partie plate (13) et une partie de logement (15), le système de générateur d'énergie (20) comprenant :
un générateur thermoélectrique, TEG, (22) intégré dans la porte intégrante (14) ;
un composant électronique (38, 42) destiné à diriger la circulation de courant au sein du TEG (22) ;
un ensemble de capteurs intégrés dans le TEG (22) destinés à déterminer les températures au sein du TEG (22) ; et
un processeur (24) destiné à commander le composant électronique (38, 42) sur la base des températures déterminées.

2. Système de générateur d'énergie (20) de la revendication 1, dans lequel le TEG (22) est situé sur une surface de la partie plate (13), éventuellement sur une surface de la partie plate (13) dans la partie de logement (15).

3. Système de générateur d'énergie (20) de l'une des revendications précédentes, dans lequel le TEG (22) est situé dans la partie de logement (15).

4. Système de générateur d'énergie (20) de l'une des revendications précédentes, dans lequel le TEG (22) est en forme de U.

5. Système de générateur d'énergie (20) de l'une des revendications précédentes, dans lequel le TEG (22) comprend :
une première couche de matériau métallique ;
une deuxième couche de matériau métallique ; et
un système de connecteur reliant la première couche à la deuxième couche ;
dans lequel le système de connecteur dirige le courant de l'une des couches vers l'autre couche.

6. Système de générateur d'énergie (20) de l'une des revendications précédentes, dans lequel le composant électronique (38, 42) est un commutateur.

7. Système de générateur d'énergie (20) de l'une des revendications précédentes, dans lequel le composant électronique (38, 42) est une diode.

8. Système de générateur d'énergie (20) de l'une des revendications précédentes, comprenant en outré :
un collecteur d'énergie destiné à collecter l'énergie générée par le TEG.

9. Système de générateur d'énergie (20) de la revendication 8, comprenant en outré :
un composant de conditionnement de puissance connecté entre le collecteur d'énergie et le processeur (24).

10. Système de générateur d'énergie (20) de l'une des revendications précédentes, dans lequel le TEG (22) est en contact direct avec des composants du dispositif.

11. Système de générateur d'énergie (20) de la revendication 5, dans lequel le matériau métallique pour la première couche est un cermet.

12. Système de générateur d'énergie (20) de la revendication 5, dans lequel le matériau métallique pour la deuxième couche est un cermet.
